# EUROPÄISCHE PATENTSCHRIFT

(11) **EP 2 900 728 B1**
(45) Veröffentlichungstag und Bekanntmachung des Hinweises auf die Patenterteilung: **25.05.2016**
(21) Anmeldenummer: 13759982.5
(22) Anmeldetag: 05.09.2013
(51) Int. Cl.: C08G 61/12, C08G 73/02, C08G 73/06, C08L 65/00, C08L 79/02, C08L 79/04

(54) **FORMULIERUNGEN ENTHALTEND LEITFÄHIGE POLYMERE SOWIE DEREN VERWENDUNG IN ORGANISCHEN, ELEKTRONISCHEN VORRICHTUNGEN**
FORMULATIONS CONTAINING CONDUCTIVE POLYMERS AND USE THEREOF IN ORGANIC ELECTRONIC DEVICES
FORMULATIONS CONCERNANT DES POLYMÈRES CONDUCTIBLES AINSI QUE LEUR UTILISATION DANS DES DISPOSITIFS ORGANIQUES, ÉLECTRONIQUES

(30) Priorität: 25.09.2012 EP 12006695
(43) Veröffentlichungstag der Anmeldung: 05.08.2015
(73) Patentinhaber: Merck Patent GmbH, 64293 Darmstadt (DE)
(72) Erfinder: BECKER, Heinrich, 64372 Ober-Ramstadt (DE); HEUN, Susanne, 65812 Bad Soden (DE)
(86) Internationale Anmeldenummer: PCT/EP2013/002673
(87) Internationale Veröffentlichungsnummer: WO 2014/048543

(56) Entgegenhaltungen:
- WO-A1-2007/020100
- WO-A2-2004/029128
- WO-A2-2007/002737

## Beschreibung

Die vorliegende Erfindung betrifft Formulierungen enthaltend dotierte, leitfähige Polymere, welche sich aufgrund ihrer hervorragenden Lochinjektionseigenschaften und ihrer hohen Leitfähigkeiten sehr gut für die Verwendung in organischen, elektronischen Vorrichtungen, vorzugsweise in Elektrolumineszenzvorrichtungen, insbesondere in deren Pufferschichten eignen. Die vorliegende Erfindung betrifft somit auch die Verwendung der erfindungsgemäßen Formulierungen in organischen, elektronischen Vorrichtungen, vorzugsweise in Elektrolumineszenzvorrichtungen, insbesondere in deren Pufferschichten. So zeigen die leitfähigen Polymere hervorragende Eigenschaften als Pufferschicht in der Photovoltaik, Phototherapie und Sensorik. Die Polymere weisen ein breites spektrales Fenster und gute Filmbildungseigenschaften auf. Die Materialien werden üblicherweise als wässrige Dispersion verarbeitet, es ist jedoch ebenfalls möglich, die Materialien als Lösung aus organischen Lösungsmitteln oder Wasser zu verarbeiten.

Dotierte leitfähige Polymere sind bekannt und finden seit langem Verwendung im Korrosionsschutz, in der Antistatik, in der gedruckten Elektronik und in organischen Elektrolumineszenzvorrichtungen. Besondere Bedeutung hat ihre Verwendung in OLEDs (**O**rganic **L**ight **E**mitting **D**iodes) und PLEDs (**P**olymeric **L**ight **E**mitting **D**iodes).

Als leitfähige Polymere werden üblicherweise Polyaniline, Polyanilin-Indium-Komplexe, Polythiophene, Poly-thieno-thiophene, Polypyrrole und Oligoaniline eingesetzt. Diese können durch Brönstedt-Säuren (polymere Säuren, monomere Säuren, sowie durch kovalent gebundene Säuregruppen) dotiert sein.

Zu den bekanntesten dotierten leitfähigen Polymeren zählen Poly-(3,4-ethylendioxythiophen) (PEDOT) und Polyanilin (PANI).

Dispersionen von Poly-(3,4-ethylendioxythiophen) (PEDOT), die unter anderem mit polymeren Sulfonsäuren dotiert sind, werden beispielsweise in der EP 0593111 A1 offenbart. Kommerzielle, wässrige PEDOT-Dispersionen sind z.B. von Heraeus unter dem Handelsnamen Clevios und von Agfa-Gevaert unter dem Handelsnamen Orgacon erhältlich.

Dispersionen aus Polyanilin (PANI) und einer polymeren Sulfonsäure, welche mit Indium versetzt sind, werden beispielsweise in der WO 2007/020100 offenbart. Weiterhin werden in diesem Dokument Polypyrrole und Polythiophene (PEDOT Derivate) mit Indium-Zusatz beschrieben. Ebenfalls beschrieben werden in diesem Dokument Dispersionen dieser Materialien sowie deren Verwendung in OLEDs. Es wird allerdings nicht auf die optoelektronische Leistungsfähigkeit und besonders auf die optische Transparenz der beschriebenen Materialsysteme eingegangen.

Weiterhin sind für OLED Anwendungen leitfähige Polythieno[3,4-b]thiophene, Polythieno[3,2-b]thiophene und Polypyrrole bekannt. Diese werden z.B. in der WO 2010/141129 beschrieben. Weiterhin ist die Verwendung fluorierter organischer Brönstedtsäuren bekannt, wie z.B. in der WO 04/029128 und der WO 04/029133 offenbart. Desweiteren werden z.B. in EP 2062870 und in EP 1773102 Oligoaniline offenbart.

Gemäß dem Stand der Technik sind die verwendeten Pufferschichten geeignet, den elektrischen Strom zu leiten, Löcher zu injizieren und Unebenheiten in Dünnfilmelektronikanwendungen, insbesondere in OLEDs, auszugleichen. Aktuell zeigen die Materialien jedoch oft nur eine unzureichende optische Transparenz und führen daher zu untragbar großen Effizienzverlusten durch Lichtabsorption.

Überraschenderweise wurde nun gefunden, dass, bei Erhalt der übrigen Funktionalität, die optischen Eigenschaften dieser leitfähigen Polymere verbessert werden können, wenn diese Materialien nach der Herstellung von Lösung bzw. Dispersion zusätzlich mit einem Oxidationsmittel versetzt werden.

Gegenstand der vorliegenden Anmeldung ist somit eine Formulierung enthaltend mindestens ein dotiertes, leitfähiges Polymer, mindestens ein Oxidationsmittel und mindestens ein Lösungsmittel.

Vorzugsweise enthält die erfindungsgemäße Formulierung ein dotiertes, leitfähiges Polymer.

Als dotiertes, leitfähiges Polymer können alle dem Fachmann für den genannten Verwendungszweck bekannten und geeigneten Polymere eingesetzt werden.

Bevorzugte leitfähige Polymere sind Polythiophene, wie z.B. Poly-(3,4-ethylendioxythiophen) und Polythiophenderivate, wie z.B. Polythienothiophene, Polyaniline und Polyanilinderivate, wie z.B. Polyanilin-Indium Komplexe, Polypyrrole sowie Oligoaniline. Diese können durch Brönstedt-Säuren (anorganische und organische Säuren, polymere Säuren, monomere Säuren, sowie durch kovalent gebundene Säuregruppen) dotiert sein. Besonders bevorzugt sind Poly-(3,4-ethylendioxythiophen) und Polyanilin, die durch Zusatz von Polysulfonsäuren dotiert sind.

Der Gehalt an dem mindestens einen dotierten, leitfähigen Polymeren in der Formulierung liegt vorzugsweise im Bereich von 0,001 bis 30 Gew.-%, besonders bevorzugt im Bereich von 0,01 bis 15 Gew.-% und ganz besonders bevorzugt im Bereich von 0,1 bis 6 Gew.-%.

Vorzugsweise enthält die erfindungsgemäße Formulierung ein Oxidationsmittel.

Als Oxidationsmittel können alle dem Fachmann bekannten Oxidationsmittel eingesetzt werden.

Bevorzugte Oxidationsmittel sind organische und anorganische Peroxide (z.B. Wasserstoffperoxid und t-Butylhydroperoxid), Persäuren (z.B. m-Chlorperoxobenzoesäure und Peressigsäure), Persulfate (z.B. Peroxodisulfat und Persulfat), Perborate, Metallsalze (z.B. Kaliumpermanganat, Kaliumhexacyanoferrat(III), Eisen(III)chlorid und Chromate), Derivate der Halogensauerstoffsäure (z.B. Perchlorate, Hypochlorite, Bromate und Periodate), Nitrate, Halogene (z.B. Chlor, Brom, Fluor und Iod), Ozon, Stickoxide, Nitrosoverbindungen und Sauerstoff.

Der Gehalt an Oxidationsmittel in der Formulierung liegt vorzugsweise im Bereich von 0,001 bis 5 Gew.-%, besonders bevorzugt im Bereich von 0,05 bis 2 Gew.-% und ganz besonders bevorzugt im Bereich von 0,01 bis 1 Gew.-%.

Das Gewichtsverhältnis von dotiertem, leitfähigen Polymer zu Oxidationsmittel in der Formulierung liegt vorzugsweise im Bereich von 1000:1 bis 1:10, besonders bevorzugt im Bereich von 500:1 bis 1:5 und ganz besonders bevorzugt im Bereich von 100:1 bis 1:1.

In einer weiteren Ausführungsform wird das Oxidationsmittel in Form eines Gases zugefügt, welches in der endgültigen Formulierung nicht mehr enthalten ist.

Vorzugsweise enthält die erfindungsgemäße Formulierung ein Lösungsmittel.

Als Lösungsmittel können ebenfalls alle dem Fachmann bekannten und für die leitfähigen Polymere geeigneten Lösungsmittel eingesetzt werden. Unter einem Lösungsmittel werden in der vorliegenden Anmeldung dabei nicht nur solche verstanden, in denen alle Komponenten der Formulierung löslich sind, sondern auch solche, in denen eine oder mehrere Komponenten der Formulierung nicht oder nicht vollständig löslich sind, so dass die Formulierung z.B. als Dispersion vorliegt.

Bevorzugte Lösungsmittel sind: Wasser, Alkohole (z.B. Methanol, Ethanol, Isopropanol, t-Butanol und Cyclohexanol), Alkane (z.B. Heptan), Cycloalkane (z.B. Cyclohexan), Alkene (z.B. 1-Hepten), Alkine, Ether (z.B. Diethylether, t-Butylmethylether und Tetrahydrofuran), Ester (z.B. Methylbenzoat), halogenierte Kohlenwasserstoffe (z.B. Dichlormethan und Trichlormethan), Aromaten (z.B. Toluol, Anisol, Methylanisol, Chlorbenzol, Methylnaphthalin und Tetralin), Lactone (z.B. 4-Butyrolacton), Carbonate (z.B. Ethylencarbonat), Sulfoxide (z.B. Dimethylsulfoxid), Nitroverbindungen (z.B. Nitromethan), Nitrile (z.B. Acetonitril), Ketone (z.B. Aceton und Butanon), Carbonsäureamide (z.B. Dimethylformamid) und Harnstoffderivate (z.B. 1,3-Dimethyl-2-imidazolidon). Ebenfalls eingesetzt werden können Gemische dieser Lösungsmittel. Besonders bevorzugt ist jedoch Wasser als Lösungsmittel.

Der Gehalt an Lösungsmittel in der Formulierung liegt vorzugsweise im Bereich von 65 bis 99,99 Gew.-%, besonders bevorzugt im Bereich von 83 bis 99,9 Gew.-% und ganz besonders bevorzugt im Bereich von 93 bis 99 Gew.-%.

Die erfindungsgemäßen Formulierungen können beispielsweise erhalten werden, indem das dotierte, leitfähige Polymer in dem mindestens einen Lösungsmittel gelöst oder dispergiert wird und das Oxidationsmitel zu der Lösung oder Dispersion hinzugegeben oder (im Fall von Gasen) durch Durchleiten eingebracht wird.

In einer weiteren Ausführungsform kann die Oxidation auch elektrochemisch durchgeführt werden.

Darüber hinaus finden die erfindungsgemäßen Formulierungen Verwendung in organischen, elektronischen Vorrichtungen. Gegenstand der vorliegenden Anmeldung ist somit auch die Verwendung der erfindungsgemäßen Formulierungen in organischen, elektronischen Vorrichtungen.

Die organische, elektronische Vorrichtung ist vorzugsweise eine organische elektrolumineszierende Vorrichtung (OLED), eine polymere elektrolumineszierende Vorrichtung (PLED), eine organische integrierte Schaltung (O-IC), ein organischer Feld-Effekt-Transistor (O-FET), ein organischer Dünnfilmtransistor (O-TFT), ein organischer, lichtemittierender Transistor (O-LET), eine organische Solarzelle (O-SC), ein organischer, optischer Detektor, ein organischer Fotorezeptor, ein organisches Feld-Quench-Device (O-FQD), eine organische, lichtemittierende elektrochemische Zelle (OLEC) oder eine organische Laserdiode (O-Laser).

Erfindungsgemäß ist es bevorzugt, dass das dotierte leitfähige Polymer als Schicht (oder in einer Schicht) in der elektronischen Vorrichtung vorliegt. Die Schichtdicke liegt dabei vorzugsweise im Bereich von 1 bis 1000 nm, besonders bevorzugt im Bereich von 5 bis 500 nm und ganz besonders bevorzugt im Bereich von 10 bis 200 nm.

Die Schicht kann beispielsweise dadurch erhalten werden, dass die erfindungsgemäße Formulierung als Dispersion oder Lösung aufgebracht und anschließend das mindestens eine Lösungsmittel entfernt wird.

Das Aufbringen der Lösung kann dabei durch alle dem Fachmann bekannten und für diesen Zweck geeigneten Verfahren erfolgen. Bevorzugt erfolgt die Aufbringung jedoch durch Spin-Coating oder mit einem beliebigen Druckverfahren, wie z.B. Siebdruck, Flexodruck oder Offsetdruck, besonders bevorzugt aber LITI (Light Induced Thermal Imaging, Thermotransferdruck) oder Ink-Jet Druck (Tintenstrahldruck). Ebenfalls bevorzugt sind kontinuierliche Beschichtungsverfahren, wie z.B. Rakeln, Tauchziehen, Rolle-zu-Rolle-Verfahren sowie Beschichtung durch Zerstäubungstechnik (Airbrush).

Auch das Entfernen des Lösungsmittels kann durch alle dem Fachmann bekannten Verfahren erfolgen. Bevorzugt wird jedoch das Lösungsmittel bei höherer Temperatur und/oder vermindertem Druck entfernt. Auch das Trocknen mittels (N)IR-Behandlung, wie z.B. in der WO 03/038923 A1 offenbart, kann vor allem in der Produktion kostengünstig und zeitsparend sein.

Im Allgemeinen werden die Schichten bei Temperaturen im Bereich von 20°C bis 300°C getrocknet, vorzugsweise im Bereich von 80°C bis 250°C, besonders bevorzugt im Bereich von 100°C bis 240°C und ganz besonders bevorzugt im Bereich von 140°C bis 220°C. Die Trocknung erfolgt dabei vorzugsweise bei Normaldruck (1013 mbar). Es ist jedoch auch möglich, die Trocknung bei vermindertem Druck durchzuführen. Die Ausheizzeiten liegen dabei vorzugsweise über 2 Minuten, besonders bevorzugt im Bereich von 3 Minuten bis 1 Stunde und ganz besonders bevorzugt im Bereich von 5 Minuten bis 20 Minuten.

Vorzugsweise wird die aus der erfindungsgemäßen Formulierung erhaltene Schicht als Pufferschicht und/oder Lochinjektionsschicht in elektrolumineszierenden Vorrichtungen, vorzugsweise organischen elektrolumineszierenden Vorrichtungen (OLEDs) oder polymeren elektrolumineszierenden Vorrichtungen (PLEDs) eingesetzt.

Dabei wurde gefunden, dass durch den Einsatz der erfindungsgemäßen Formulierung das spektrale Fenster der optischen Durchlässigkeit breiter wird, dass sich jedoch die sonstigen Parameter, wie z.B. Lochinjektionseigenschaften, Benetzungseigenschaften, Leitfähigkeit, Viskosität, viskoelastisches Verhalten und pH Wert der Materialien, nicht negativ verändern. Insbesondere ist die Absorption am langwelligen Ende des visuellen Spektrums deutlich geringer. Die hergestellten Schichten zeigen eine erhöhte Transparenz, während die anderen Eigenschaften, wie z.B. Dicke, mechanische Härte, Austrittsarbeit und Oberflächenrauhigkeit, vergleichbar bleiben.

Die Eigenschaften in optoelektronischen Dünnfilmanwendungen profitieren von dem verbreiterten optischen Fenster. Dies trifft insbesondere auf organische Leuchtdioden und organische Solarzellen zu. Insbesondere organische Leuchtdioden zeigen im roten Spektralbereich eine höhere Effizienz bei guter Lebensdauer. Besonders im Fall von Mehrschichtdevices und/oder weißen Leuchtdioden ist der größere Spektralbereich von Vorteil, da keine der farbgebenden, spektralen Komponenten selektiv herausgefiltert wird. Dies ist besonders dann wichtig, wenn für Beleuchtungseinheiten die Effizienz durch verschiedene Methoden zur Verbesserung der Lichtauskopplung erhöht werden soll. Hier durchlaufen die emittierten Photonen die einzelnen Schichten der Bauteile mehrfach, was im Falle einer roten Absorption der Pufferschicht zu einem selektiven Verlust des roten, spektralen Anteils führt.

Die folgenden Beispiele sollen die Erfindung erläutern, ohne sie einzuschränken. Insbesondere sind die darin beschriebenen Merkmale, Eigenschaften und Vorteile der dem betreffenden Beispiel zu Grunde liegenden, definierten Verbindungen auch auf andere, nicht im Detail aufgeführte, aber unter den Schutzbereich der Ansprüche fallende Verbindungen anwendbar, sofern an anderer Stelle nichts Gegenteiliges gesagt wird.

### Ausführungsbeispiele

Die nachfolgenden Synthesen werden, sofern nicht anders angegeben, in 3-Halsrundkolben an Luft durchgeführt. Die Edukte werden, sofern nicht anders erwähnt, von den Firmen ALDRICH bzw. ABCR bezogen.

### Beispiel 1

Oxidation von Polyanilin-Dispersionen

### 1a) mit Wasserstoffperoxid

150 ml einer gut gerührten Dispersion von Polyanilin-Polystyrolsulfonsäure-Indium-Komplex (PANI-In-PSSH) (4% in Wasser, die Darstellung erfolgt analog der WO 2007/020100, Beispiel 7) wird mit 0,42 ml einer 30%igen Wasserstoffperoxidlösung in Wasser versetzt und bei 60°C 1 Stunde gerührt.
Viskosität: 3,18 mPas bei 40 1/s; pH = 1,55

### 1b) mit Wasserstoffperoxid

Analog zu Beispiel 1 a werden 150 ml einer gut gerührten Dispersion von Polyanilin-Polystyrolsulfonsäure-Indium-Komplex (PANI-In-PSSH) mit 0,85 ml einer 30%igen Wasserstoffperoxidlösung in Wasser versetzt und bei 60°C 1 Stunde gerührt.
Viskosität: 2,98 mPas bei 40 1/s; pH = 1,39

### 1c) mit Kaliumpermanganat

Analog zu Beispiel 1 a werden 150 ml einer gut gerührten Dispersion von Polyanilin-Polystyrolsulfonsäure-Indium-Komplex (PANI-In-PSSH) mit 1,27 g (8 mmol) Kaliumpermanganat versetzt und bei 60°C 1 Stunde gerührt. Die Dispersion wird durch einen 0,5 µm Filter filtriert.
Viskosität: 3,01 mPas bei 40 1/s; pH = 1,52

### 1d) mit Kaliumperoxodisulfat

Analog zu Beispiel 1a werden 150 ml einer gut gerührten Dispersion von Polyanilin-Polystyrolsulfonsäure-Indium-Komplex (PANI-In-PSSH) mit 2,16 g (4 mmol) Kaliumperoxodisulfat versetzt und bei 60°C 1 Stunde gerührt. Viskosität: 2,90 mPas bei 40 1/s; pH = 1,51

### 1e) mit Peressigsäure

Analog zu Beispiel 1 a werden 150 ml einer gut gerührten Dispersion von Polyanilin-Polystyrolsulfonsäure-Indium-Komplex (PANI-In-PSSH) mit 1,33 ml (8 mmol) 32%iger Peressigsäure (in Essigäure) versetzt und bei 60°C 1 Stunde gerührt.
Viskosität: 3,21 mPas bei 40 1/s; pH = 1,74

### 1f) mit Natriumhypochlorit

Analog zu Beispiel 1a werden 150 ml einer gut gerührten Dispersion von Polyanilin-Polystyrolsulfonsäure-Indium-Komplex (PANI-In-PSSH) mit 5,9 ml (8 mmol) 10%iger Natriumhypochlorit Lösung (in Wasser) versetzt und bei 60°C 1 Stunde gerührt.
Viskosität: 2,88 mPas bei 40 1/s; pH = 1,39

### 1g) mit Ozon

Durch 150 ml einer gut gerührten Dispersion von Polyanilin-Polystyrolsulfonsäure-Indium-Komplex (PANI-In-PSSH) wird mittels eines Ozongenerators (Innovatec-CMG 10-4) für eine Stunde Ozon (~10 g O₃) durchgeleitet. Zur Entfernung des überschüssigen Ozons wird für eine Stunde mit Stickstoff gespült.
Viskosität: 3,21 mPas bei 40 1/s; pH = 1,29

### Beispiel 2

Oxidation von Poly-(3,4-ethylendioxy)thiophen-Polystyrolsulfonat (PEDOT-PSSH)

### 2a) mit Wasserstoffperoxid

100 ml einer gut gerührten Dispersion von PEDOT-PSSH (1,7% in Wasser, PEDOT/PSSH 1/6, das Material wird unter der Bezeichnung Clevios Al4083 von H.C.Starck bezogen) wird mit 0,1 ml einer 30%igen Wasserstoffperoxidlösung in Wasser versetzt und bei 60°C 1 Stunde gerührt. Viskosität: 7,18 mPas bei 40 1/s; pH = 2,03

### Beispiel 3

Oxidation von Phenyltetraanilin-5-Sulfosalicylsäure

### 3a) mit t-Butylhydroperoxid

Diese Reaktion wird unter N₂ Überlagerung durchgeführt. 100 ml einer gut gerührten Lösung von Phenyltetraanilin-5-Sulfosalicylsäure (5% in 1,3-Dimethyl-2-imidazolidon - Cyclohexanol Gemisch 1:1, Darstellung siehe EP 1773102, Beispiel 1) wird mit 2,9 ml einer 5,5 M tert-Butylhydroperoxid Lösung in Decan versetzt und bei 60°C 1 Stunde gerührt.
Viskosität: 1,28 mPas bei 40 1/s; pH = 3,32

### Anwendungsbeispiele:

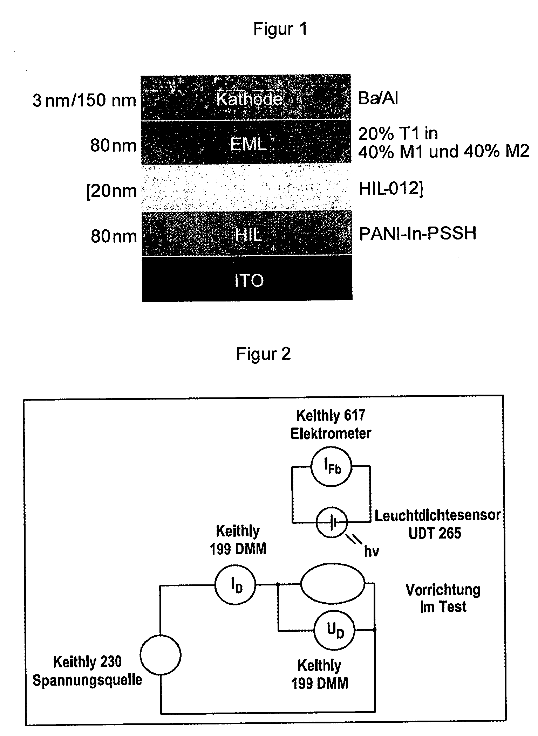

Löslich prozessierte OLEDs haben im allgemeinen einen einfacheren Aufbau als im Vakuum hergestellte Vorrichtungen. Letztere enthalten eine Vielzahl von Schichten mit unterschiedlichen Funktionen. Die einzelnen Schichten werden übereinander aufgedampft, wobei die erste Schicht, die auf die Anode (im allgemeinen ITO) aufgebracht wird, oft eine Lochinjektionsschicht ("HIL": hole injection layer) ist. In Figur 1 ist der Aufbau einer typischen, wenige Schichten enthaltenden OLED, die aus Lösung prozessiert wird, abgebildet. Die Herstellung solcher Bauteile lehnt sich an die Herstellung polymerer Leuchtdioden (PLEDs) an, die in der Literatur bereits vielfach beschrieben ist (z.B. in der WO 2004/037887 A2). Auch hier ist die erste Schicht, die auf der Anode abgeschieden wird, eine Lochinjektionsschicht, die oft auch als Pufferschicht bezeichnet wird. In beiden Typen von Vorrichtungen können die erfindungsgemäßen Materialien eingesetzt werden.

### Vergleichsbeispiel V1:

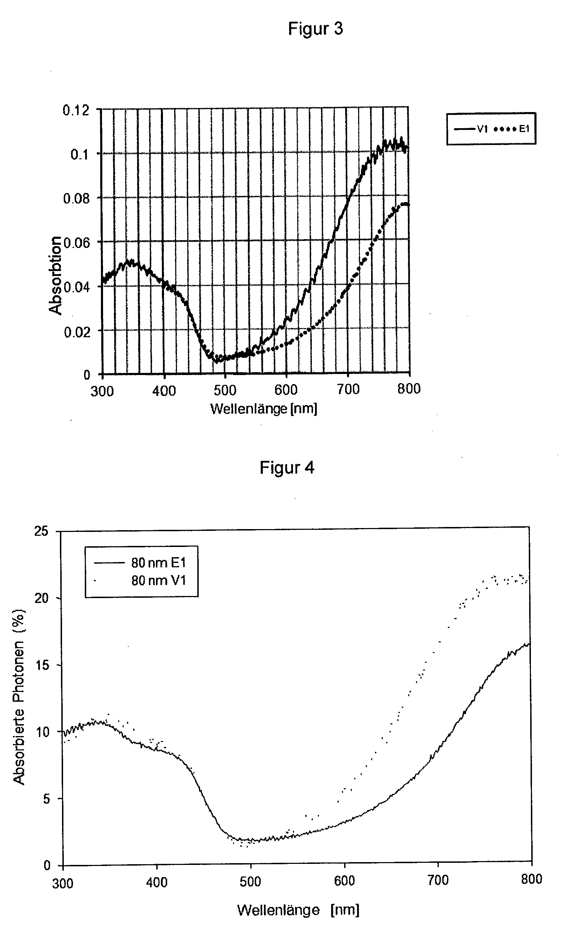

Eine 80 nm dicke Schicht Polyanilin-Polystyrolsulfonsäure-Indium-Komplex (4% in Wasser, die Darstellung erfolgt analog der WO 2007/020100, Beispiel 7) wird mit Hilfe eines Spincoaters bei einer Spinrate von 2530 rpm auf einem Glasträger abgeschieden und 10 Minuten bei 180°C ausgeheizt. Der Film wird anschließend vor Wasser geschützt (Argon-Transportbox). Das gemessene Absorptionsspektrum ist in Figur 3 dargestellt.

### Beispiel E1:

Ein erfindungsgemäßer Film der Dispersion aus Beispiel 1a wird auf gleiche Art und Weise wie in Vergleichsbeispiel V1 auf einem Glasträger abgeschieden. Die benötigte Spinrate für 80 nm beträgt 2300 rpm. Der Film wird ebenfalls 10 Minuten bei 180°C ausgeheizt und vor Wasser geschützt. Das gemessene Absorptionsspektrum ist in Figur 3 dargestellt. Die Absorption im roten Spektralbereich ist deutlich reduziert.

### Vergleichsbeispiel V2:

In der für lösungsprozessierte Vorrichtungen typischen Devicekonfiguration der Figur 1 wird zunächst eine Interlayer, in diesem Fall HIL-012 (0,5% aus Toluol) (Merck KGaA), auf der analog Vergleichsbeispiel V1 abgeschiedenen Pufferschicht aufgebracht. Die für 20 nm Interlayerschicht benötigte Spinrate beträgt 2440 rpm, der Interlayerfilm wird nach dem Spincoaten unter Schutzgasatmosphäre eine Stunde bei 180°C ausgeheizt.

### Beispiel E2:

Bei der Verwendung der erfindungsgemäßen Dispersion aus Beispiel 1 a beträgt die Spinrate für die Interlayerschicht (HIL-012) 2380 rpm, womit sie also praktisch identisch mit der Spinrate für das Vergleichsbeispiel V2 ist.

Dies bedeutet, dass auch die Oberflächenspannung und damit die Benetzbarkeit des Films durch die Verwendung der erfindungsgemäßen Dispersionen nicht messbar verändert wird.

### Beispiele E3 bis E5, V3: Herstellung von löslich prozessierten OLEDs

Löslich prozessierte OLEDs können mit den erfindungsgemäßen Formulierungen in der Vorrichtungsstruktur der Figur 1 sowohl mit als auch ohne Interlayer hergestellt werden. Als Interlayermaterial dient jeweils HIL-012 von Merck. Als Emissionsschicht ("EML", s. Figur 1) wird in beiden Fällen eine 80 nm dicke Schicht durch Spin-Coating aufgebracht. Bei den in der Emissionsschicht verwendeten Materialien handelt es sich um einen grünen Triplett-Emitter T1 in einer Matrix aus den Komponenten M1 und M2. Das Lösungsmittel ist Chlorbenzol, die Anteile der einzelnen Materialien betragen 20 Gew.-% T1, 40 Gew.-% M1 und 40 Gew.-% M2.

Struktur des Emitters T1:

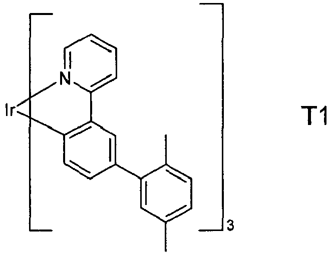

Struktur der Matrix M1:

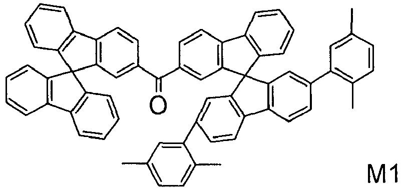

Struktur der Matrix M2:

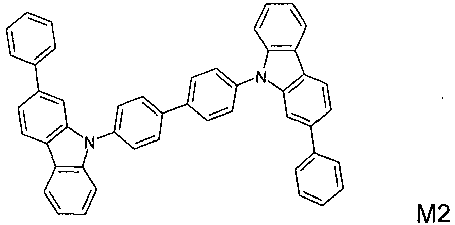

### Beispiel E3: OLED im Deviceaufbau der Figur 1 (mit Interlayer)

Die benötigte Spinrate für eine 80 nm-EML-Schicht auf HIL-012 beträgt 1010 rpm. Um einen qualitativ hochwertigen Film zu erhalten, wird die Lösung auf 60°C erwärmt und bei dieser Temperatur aufgeschleudert. Nach dem Spincoaten wird der Film unter Schutzgasatmosphäre auf einer Heizplatte für 10 Minuten bei 180°C ausgeheizt. Als Kathode werden 3 nm Barium und 150 nm Aluminium aufgedampft. Die nach der Probenherstellung verkapselten Vorrichtungen werden mit einem Meßaufbau, wie in Figur 2 dargestellt, charakterisiert. Zusätzlich wird ein Elektrolumineszenzspektrum bei 1000 cd/m² gemessen, aus dem die Farbkoordinaten abgeleitet werden (CIE: Commission Internationale de l'Eclairage, Normalbetrachter von 1931). Von den Vorrichtungen wird ebenfalls die Lebensdauer ("LT") gemessen, wobei als Lebensdauer der Vorrichtung diejenige Zeit verstanden wird, nach der die Startleuchtdichte (in diesem Fall 1000 cd/m²) auf 50% abgeklungen ist. Die Ergebnisse in Tabelle 1 zeigen, dass die erfindungsgemäße Dispersion des Beispiels 1 b trotz des einfachen Vorrichtungsaufbaus zu sehr guten Triplett-Grün-Devices führt.

**Tabelle 1: Deviceergebnisse zu E3**

| Bsp. | Max. Eff. [cd/A] | Max. EQE [%] | U@ 1000 cd/m² [V] | CIE [x/y] | LT @ 1000 cd/m² [hrs] |
|---|---|---|---|---|---|
| E3 | 26,1 | 7,3 | 6,7 | 0,34 / 0,62 | 6500 |

### Beispiele V3, V4, E4 bis E6: OLEDs im Deviceaufbau der Figur 1 (ohne Interlayer)

Noch kostengünstiger und robuster in der Herstellung ist ein Vorrichtungsaufbau wie in Figur 1, bei dem die Interlayer weggelassen wird. Bringt man die EML direkt auf die auch für das Vergleichsbeispiel V1 verwendete PANI-In-PSSH-Schicht auf, wird eine sehr einfache grüne OLED (Vergleichs-Device-Beispiel V3) erhalten. Als weiteres Vergleichsbeispiel kann außerdem PEDOT als Puffermaterial verwendet werden (Vergleichs-Device-Beispiel V4). Letzteres wird als ebenfalls wässrige Dispersion von Heraeus bezogen (Clevios P 4083 Al) und wird analog der PANI-Dispersion verarbeitet und ausgeheizt (Spinrate für 80 nm: 4500 rpm). Zum Vergleich werden Vorrichtungen mit erfindungsgemäßen Pufferschichten 1 a, 1b und 1f gebaut (Beispiele E4, E5 und E6). Die Ergebnisse sind in Tabelle 2 zusammengefasst. Die Spinraten der EML auf der Pufferschicht liegen alle sehr dicht zusammen, was wiederum zeigt, dass die Haftung der EML auf den erfindungsgemäßen Schichten ebenso gut ist wie auf dem in der Industrie weitverbreiteten PEDOT. Von den Vorrichtungen wird ebenfalls die Lebensdauer ("LT") gemessen, wobei als Lebensdauer der Vorrichtung diejenige Zeit verstanden wird, nach der die Startleuchtdichte (in diesem Fall 1000 cd/m²) auf 50% abgeklungen ist.

**Tabelle 2: Deviceergebnisse zu V3, V4, E4, E5 und E6**

| Bsp. | Spinrate EML [rpm] | Max. Eff. [cd/A] | Max. EQE [%] | U@ 1000 cd/m² [V] | CIE [x/y] | LT @ 1000 cd/m² [hrs] |
|---|---|---|---|---|---|---|
| V3 | 1010 | 16,7 | 4,7 | 7,0 | 0,34/0,62 | 1600 |
| V4 | 1200 | 22,5 | 6,2 | 6,5 | 0,33/0,62 | 1300 |
| E4 | 1210 | 21,8 | 6,0 | 6,2 | 0,34/0,62 | 2300 |
| E5 | 1210 | 29,7 | 8,2 | 6,6 | 0,34/0,62 | 5600 |
| E6 | 1210 | 21,4 | 5,7 | 7,1 | 0,34/0,62 | 2500 |

Wie man aus den Ergebnissen der Tabelle 2 erkennen kann, führt die Verwendung der erfindungsgemäßen Formulierungen 1 a, 1b und 1f in den Vorrichtungen E4 bis E6 im Vergleich zum Stand der Technik, der Vorrichtung V3, durchgängig zu einer deutlichen Verbesserung. Die Lebensdauer der Vorrichtung E5 kommt trotz des Weglassens der Interlayer fast an die von Vorrichtung E3 heran, die Effizienz ist im Vergleich dazu sogar noch einmal verbessert.

### Vergleich von EL-Spektren weißer Devices auf V1 und E1:

Berechnet man aus dem Absorptionsspektrum in Figur 3 die Transmission der Filme [T = 10^{(-E)}] und anschließend die daraus resultierende Zahl der vom Film absorbierten Photonen [(1-T)∗100], wird deutlich, wie groß der Unterschied und damit der Einfluß auf das spektrale Fenster für die aus den erfindungsgemäßen Formulierungen hergestellten Filme im Vergleich zum Stand der Technik ist (s. Figur 4). Während der Film aus V1 z.B. bei 780 nm 20% aller Photonen absorbiert, sind es bei dem Film aus E1 nur 15%. Für satt rote Devices mit einer Emissionswellenlänge von 625 nm absorbiert V1 etwa 7,2 %, E1 aber nur etwa 3,9%. Tabelle 3 zeigt den Anteil absorbierter Photonen für verschiedene ausgewählte Wellenlängen.

**Tabelle 3**

| Wellenlänge | V1 | E1 |
|---|---|---|
| 440 nm | 6,48 % | 6,50 % |
| 500 nm | 1,48 % | 1,68 % |
| 550 nm | 2,88 % | 2,09 % |
| 580 nm | 4,23 % | 2,57 % |
| 625 nm | 7,19 % | 3,87 % |

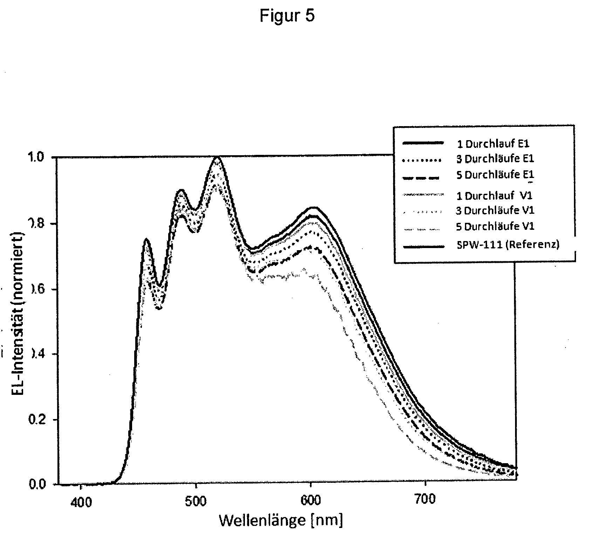

Besonders die hohe Absorption im gelb-roten Bereich ist von entscheidender Bedeutung für die Anwendung der Schichten in Devices für Beleuchtungsanwendungen, wo man sogenannte "warm-weiße" Beleuchtungselemente mit einem hohen Orangeanteil bauen möchte. Hier gibt es das generelle Problem, dass die rote Emission vor allem im Vergleich zu Grün meistens niedrigere Effizienzen zeigt und man zusätzlich, um mit bereits existierender Beleuchtungstechnologie (Glühbirnen, Energiesparlampen, LEDs) in puncto Energieverbrauch konkurrieren zu können, oft zu Auskoppeloptiken greift, bei denen die Schicht mehrfach durchlaufen werden kann. Figur 5 zeigt das EL-Spektrum einer SPW-111-Device (einem weißen OLED-Polymer erhältlich bei Merck) wie es sich nach einem, drei und fünf Durchläufen durch die V1- bzw. E1-Schicht verändern würde. Dazu wurde ein auf 1 normiertes EL-Spektrum einer Standard-SPW-111-Device (löslich prozessiert wie in WO 2004/037887 A2 beschrieben) jeweils mit der Transmission von V1 bzw. E1 für die Zahl der Durchläufe multipliziert. Abgesehen vom generellen Effizienzverlust fällt die Farbverschiebung für die Pufferschicht nach dem Stand der Technik V1 auf, der Rotanteil im Spektrum sinkt massiv. Gleiches ist natürlich auch im viel einfacheren Fall einer dickeren Pufferschicht der Fall, wie sie aus Gründen der Produktionsausbeute gerne in großtechnischen Prozessen eingesetzt wird. Typisch sind hier Schichtdicken von 200 bis 250 nm, was rechnerisch in etwa den Spektren bei 3 Durchläufen entspricht (gepunktete Spektren). Auch hier ist die Farbänderung und der Verlust des Rotanteils bereits deutlich zu bemerken.

## Patentansprüche

1. Formulierung enthaltend mindestens ein dotiertes, leitfähiges Polymer, mindestens ein Oxidationsmittel und mindestens ein Lösungsmittel.

2. Formulierung nach Anspruch 1, **dadurch gekennzeichnet, dass** als leitfähiges Polymer ein Polythiophen, ein Polythiophenderivat, ein Polyanilin, ein Polyanilinderivat, ein Polypyrrol oder ein Oligoanilin eingesetzt wird.

3. Formulierung nach Anspruch 1 oder 2, **dadurch gekennzeichnet, dass** der Gehalt an dem mindestens einen dotierten, leitfähigen Polymer in der Formulierung im Bereich von 0,001 bis 30 Gew.% liegt.

4. Formulierung nach einem oder mehreren der Ansprüche 1 bis 3, **dadurch gekennzeichnet, dass** als Oxidationsmittel organische und anorganische Peroxide, Persäuren, Persulfate, Perborate, Metallsalze, Derivate der Halogensauerstoffsäure, Nitrate, Halogene, Ozon, Stickoxide, Nitrosoverbindungen und/oder Sauerstoff eingesetzt werden.

5. Formulierung nach Anspruch 4, **dadurch gekennzeichnet, dass** der Gehalt an dem mindestens einen Oxidationsmittel in der Formulierung im Bereich von 0,001 bis 5 Gew.% liegt.

6. Formulierung nach einem oder mehreren der Ansprüche 1 bis 5, **dadurch gekennzeichnet, dass** das Gewichtsverhältnis von dotiertem, leitfähigen Polymer zu Oxidationsmittel in der Formulierung im Bereich von 1000:1 bis 1:10 liegt.

7. Formulierung nach einem oder mehreren der Ansprüche 1 bis 6, **dadurch gekennzeichnet, dass** als Lösungsmittel Wasser, Alkohole, Alkane, Cycloalkane, Alkene, Alkine, Ether, Ester, halogenierte Kohlenwasserstoffe, Aromaten, Lactone, Carbonate, Sulfoxide, Nitroverbindungen, Nitrile, Ketone, Carbonsäureamide oder Harnstoffderivate, bzw. Gemische dieser Lösungsmittel eingesetzt werden.

8. Formulierung nach Anspruch 7, **dadurch gekennzeichnet, dass** der Gehalt an dem mindestens einen Lösungsmittel in der Formulierung im Bereich von 65 bis 99,99 Gew.% liegt.

9. Verwendung einer Formulierung nach einem oder mehreren der Ansprüche 1 bis 8 in organischen, elektronischen Vorrichtungen.

10. Verwendung einer Formulierung nach Anspruch 9, **dadurch gekennzeichnet, dass** die organische, elektronische Vorrichtung eine elektrolumineszierende Vorrichtung ist.

## Claims

1. Formulation comprising at least one doped, conductive polymer, at least one oxidant and at least one solvent.

2. Formulation according to Claim 1, **characterised in that** the conductive polymer employed is a polythiophene, a polythiophene derivative, a polyaniline, a polyaniline derivative, a polypyrrole or an oligoaniline.

3. Formulation according to Claim 1 or 2, **characterised in that** the content of the at least one doped, conductive polymer in the formulation is in the range from 0.001 to 30% by weight.

4. Formulation according to one or more of Claims 1 to 3, **characterised in that** the oxidants employed are organic and inorganic peroxides, peracids, persulfates, perborates, metal salts, derivatives of halogen oxyacid, nitrates, halogens, ozone, nitrogen oxides, nitroso compounds and/or oxygen.

5. Formulation according to Claim 4, **characterised in that** the content of the at least one oxidant in the formulation is in the range from 0.001 to 5% by weight.

6. Formulation according to one or more of Claims 1 to 5, **characterised in that** the weight ratio of doped, conductive polymer to oxidant in the formulation is in the range from 1000:1 to 1:10.

7. Formulation according to one or more of Claims 1 to 6, **characterised in that** the solvents employed are water, alcohols, alkanes, cycloalkanes, alkenes, alkynes, ethers, esters, halogenated hydrocarbons, aromatic compounds, lactones, carbonates, sulfoxides, nitro compounds, nitriles, ketones, carboxamides or urea derivatives, or mixtures of these solvents.

8. Formulation according to Claim 7, **characterised in that** the content of the at least one solvent in the formulation is in the range from 65 to 99.99% by weight.

9. Use of a formulation according to one or more of Claims 1 to 8 in organic, electronic devices.

10. Use of a formulation according to Claim 9, **characterised in that** the organic, electronic device is an electroluminescent device.

## Revendications

1. Formulation comprenant au moins un polymère conducteur dopé, au moins un oxydant et au moins un solvant.

2. Formulation selon la revendication 1, **caractérisée en ce que** le polymère conducteur utilisé est un polythiophène, un dérivé de polythiophène, un polyaniline, un dérivé de polyaniline, un polypyrrole ou un oligoaniline.

3. Formulation selon la revendication 1 ou 2, **caractérisée en ce que** la teneur de l'au moins un polymère conducteur dopé dans la formulation est dans la plage de 0,001 à 30% en poids.

4. Formulation selon une ou plusieurs des revendications 1 à 3, **caractérisée en ce que** les oxydants utilisés sont peroxydes, peracides, persulfates, perborates, sels métalliques, dérivés d'oxyacides d'halogène, nitrates, halogènes, ozone, oxydes d'azote, composés nitroso et/ou oxygène, organiques et inorganiques.

5. Formulation selon la revendication 4, **caractérisée en ce que** la teneur de l'au moins un oxydant dans la formulation est dans la plage de 0,001 à 5% en poids.

6. Formulation selon une ou plusieurs des revendications 1 à 5, **caractérisée en ce que** le rapport en poids polymère conducteur dopé sur oxydant dans la formulation est dans la plage de 1000:1 à 1:10.

7. Formulation selon une ou plusieurs des revendications 1 à 6, **caractérisée en ce que** les solvants utilisés sont eau, alcools, alcanes, cyclo-alcanes, alcènes, alcynes, éthers, esters, hydrocarbones halogénés, composés aromatiques, lactones, carbonates, sulfoxydes, composés nitro, nitriles, cétones, carboxamides ou dérivés d'urée, ou des mélanges de ces solvants.

8. Formulation selon la revendication 7, **caractérisée en ce que** la teneur de l'au moins un solvant dans la formulation est dans la plage de 65 à 99,99% en poids.

9. Utilisation d'une formulation selon une ou plusieurs des revendications 1 à 8 dans des dispositifs électroniques organiques.

10. Utilisation d'une formulation selon la revendication 9, **caractérisée en ce que** le dispositif électronique organique est un dispositif électroluminescent.
